# EUROPÄISCHE PATENTANMELDUNG

(11) **EP 1 887 695 A2**
(43) Veröffentlichungstag der Anmeldung: **13.02.2008**
(21) Anmeldenummer: 07012648.7
(22) Anmeldetag: 28.06.2007
(51) Int. Cl.: H03K 17/18

(54) **Überwachungsschaltung mit einem Mikrocontroller**

(30) Priorität: 12.08.2006 DE 102006037957
(71) Anmelder: Forschungszentrum Karlsruhe GmbH, 76133 Karlsruhe (DE)
(72) Erfinder: Klosek, Heinrich, 76703 Kraichtal (DE); Oberle, Reinhold, 75438 Knittlingen (DE)
(74) Vertreter: Rückert, Friedrich

(57) **Zusammenfassung**

Ein microcontrollerüberwachter Schalter für eine elektronische Steuer-/Schalteinrichtungung, wird beschrieben. Er besteht aus: einem Taster zum Ein/Ausschalten, der einerseits an eine Batterie, gefolgt von einem Spannungsregler, und andrerseits an einen Spannungsbegrenzer, gefolgt von einer ersten elektronischen Rückflusssperre, angeschlossen ist;
aus einem mit einem Bezugspotential verbundenen Schaltelement, das mit dem Shutdown-Eingang, SHD, des Spannungsreglers verbunden ist, wobei der Shutdown-Eingang über einen Spannungsteiler mit dem Ausgang des Spannungsreglers verbunden und an den als Überwachungsport definierten Kontakt, Int.Port, angeschlossen ist;
einem an den Spannungsregler angeschlossenen Energiespeicher mit elektronischer Rückflusssperre, der mit einem Versorgungskontakt, VSS, und einem Kontakt auf Bezugspotential, VDD, des Microcontrollers verbunden ist.

Der Microcontroller überwacht das Ein- und Ausschalten programmfestgelegt und gebraucherindividuell.

## Beschreibung

Die Erfindung betrifft eine Überwachungsschaltung mit einem Mikrocontroller für einen Schalter zum Ein- und Ausschalten einer Steuerelektronik und ein Verfahren zum Betreiben der Überwachungsschaltung.

In vielen Bereichen gibt es technische Einrichtungen, die vor zufälligem, unbeabsichtigtem Ein- oder Aus-/Abschalten bewahrt werden sollen, bzw. müssen, wie das Anlassen eines Autos, das Abschalten einer Heizungsanlage, das Einschalten einer Transporteinrichtung, das Abschalten einer Hebeeinrichtung, um nur Anwendungsbereiche beispielhaft anzudeuten. Gemeinsam ist, dass die zufällige oder unbeabsichtigte Handlung keine Folge haben und nur eine bewusste Aktion eine angestrebte Folge initiieren soll.

In der WO 03/044955 wird beschrieben, wie ein elektrisches Haushaltsgerät mit einem Hauptschalter zum Ein-/Ausschalten der Stromversorgung versehen ist. Der Hauptschalter hat eine vorbestimmte Einschaltbetätigung, während welcher er betätigt werden muss, damit er von seiner Ausstellung in seine Einstellung umschaltet. Die Länge der Einschalt- bzw. Betätigungszeitdauer innerhalb bestimmter Grenzen ist durch ein hierfür vorgesehenes Zeitdauer-Einstellmittel frei wählbar und einstellbar.

Eine Schaltungsanordnung für programmgesteuerte Haushaltsgeräte zur Sicherung der von einer Bedienperson eingegebenen Steuer- und Dateninformationen gegen deren Löschung bei ungewollter Betätigung einer Löschtaste wird in der DE 29 23 155 beschrieben. Sie ist ausgezeichnet dadurch, dass einerseits zwischen der Löschtaste und der durch diese rücksetzbaren Steuereinrichtung ein Verknüpfungselement geschaltet ist. Andrerseits ist zwischen der Löschtaste und dem Steuereingang des Verknüpfungselements ein zeitgesteuertes Schaltwerk derart angeordnet, dass zur Löschung der Steuereinrichtung die Löschtaste zumindest zweimal betätigt ist. Dabei ist bei zumindest einer Betätigung der Löschtaste das zeitgesteuerte Schaltwerkteil setzbar und über dieses Verknüpfungselement für zumindest eine weitere Betätigung der Löschtaste innerhalb einer durch das zeitgesteuerte Schaltwerkteil bestimmten Zeitspanne durchsteuerbar.

Der Erfindung liegt die Aufgabe zugrunde, eine Steuerelektronik über einen Taster an Stelle eines Schalters ein- und auszuschalten, wobei die Aufgabenstellung verlangt, die Zufälligkeit beim Ausschalten oder das unbeabsichtigte Ausschalten zu vermeiden. Mit dem Einschalten war bei der speziellen Aufgabenstellung keine Problematik verbunden, da das Einschalten lediglich die Steuerelektronik aktiviert aber keine Aktionen einleitet.

Die Aufgabe wird durch eine Überwachungsschaltung mit einem Mikrocontroller 1 für einen Schalter zum Ein- und Ausschalten einer Steuerelektronik gemäß Anspruch 1 und ein Verfahren zum Betreiben der Überwachungsschaltung gemäß Anspruch 4 gelöst.

Nach Anspruch 1 besteht die Überwachungsschaltung mit einem Mikrocontroller 1 aus einem Taster 5 mit zwei Anschlüssen, dessen erster Anschluss an eine Batterie 4, gefolgt von einem Spannungsregler 3 und dessen zweiter Anschluss an einen Spannungsbegrenzer 6, gefolgt von einer ersten elektronischen Rückflusssperre 7 und einem Schaltelement 8, angeschlossen ist. Dabei ist das Schaltelement 8 mit einem Bezugspotential, üblicherweise oder meist Erdpotential, und mit dem Shutdown-Eingang, Ein/Aus, des Spannungsreglers 3 verbunden. Der Shutdown-Eingang, Ein/Aus, ist über einen Spannungsteiler 9 mit dem Ausgang des Spannungsreglers 3 verbunden und an den als Überwachungsport definierten Kontakt, Int.Port, angeschlossen. An den Spannungsregler 3 ist der Energiespeicher mit der zweiten elektronischen Rückflusssperre 2 angeschlossen, und zwar an den Versorgungskontakt, VSS, und den Kontakt auf Bezugspotential, VDD, des Microcontrollers 1. Der Spannungsregler 3 ist also über den Shutdown-Eingang ein- und ausschaltbar.

Zur Vermeidung der sofortigen Entladung des Energiespeichers mit der zweiten elektronischen Rückflusssperre 2 kann ein zusätzlicher Kondensator C3 an den auf dem Versorgungskontakt VSS liegenden Ausgang des Spannungsreglers 3 angeschlossen sein, der zunächst für die Anfangszeit der höheren Spannung an ihm gegenüber der an dem Energiespeicher 2 die Energieversorgung des Mikrocontrollers bis zur Spannungsgleichheit übernimmt.

Die Überwachungsschaltung mit einem Mikrocontroller wird gemäß dem Verfahrensanspruch 4 folgendermaßen betrieben:
Zunächst wird zum Einschalten Taster 5 gedrückt und seine beiden verwendeten Kontakte während der Tastzeit überbrückt, es wird ein Schließerkontakt des Tasters 5 verwendet. Über den Schließer wird die im Spannungsbegrenzer 6 reduzierte Batteriespannung über die erste elektronische Rückflusssperre 7 an dem Shutdown-Eingang des Spannungsreglers 3 gelegt, der dadurch eingeschaltete wird. Der Shutdown-Eingang am Spannungsregler 3 wird über den Spannungsteiler 9, der an einen stabilisierten Ausgang des Spannungsreglers 3 angeschlossen ist, auf dem anfänglich Pegel, dem High-Pegel, gehalten und bleibt damit eingeschaltet - Selbsthaltung. Durch den eingeschalteten Spannungsregler 3 wird der Microcontroller 1 über den Energiespeicher mit der zweiten elektronischen Rückflusssperre 2 energetisch versorgt. In diesem Zustand wird die Kontrolle über den Zustand des Schalters von einem eingeprägten Überwachungsprogramm im Microcontroller 1 übernommen. Die elektronische Steuer-/Schalteinrichtung ist aktiviert und kann bedient werden.

Aus diesem Zustand heraus kann die Abschaltung des Schalters erfolgen. Hierzu wird erneut der Taster 5 gedrückt. Diese Betätigung muss/soll, um wirksam zu sein, bewusst durch den Benutzer erfolgen, darf nicht durch eine zufällige, unbeabsichtigte Berührung des Tasters schon abgeschaltete werden. Der Benutzer betätigt den Taster 5 zum bewussten Abschalten programmfestgelegt, gebraucherindividuell. Durch dieses bewusste Betätigen des Tasters 5 wird an dem Kontakt für die Zustandsüberwachung, int. Port, des Mikrocontrollers 1 ein High-Pegel > 0,25 x Vdd registriert, worauf nach einer Plausibilitätsprüfung der gebraucherindividuell angepassten Betätigung des Tasters 5 die programmfestgelegte Abschaltsequenz eingeleitet wird. Von dem Microcontroller 1 werden dann alle laufenden Prozesse gemäß dem eingeprägten Überwachungsprogramm beendet, der tatsächliche Abschaltvorgang eingeleitet und durchgeführt.

Um den Spannungsregler abzuschalten, wird auf dem Steuerkontakt, µP-Kontakt, des Microcontrollers 1 ein High-Potential angelegt und an den Steuereingang des Schaltelements 8 geleitet. Dadurch wird das Schaltelement 8 in den leitenden Zustand versetzt und der SHD-Eingang des Spannungsreglers 3 auf Bezugspotential des Schaltelements 8 gelegt. Jetzt schaltet der Spannungsregler 3 vollends programmgemäß ab und die elektronische Steuer-/Schalteinrichtung ist deaktiviert.

Während dieses Abschaltens wird der Microcontroller 1 über den Energiespeicher mit zweiter elektronischer Rückflusssperre 2 so lange energetisch versorgt, bis der Abschaltvorgang durch das Überführen des Schaltelements 8 in den leitenden Zustand und damit dem Legen des Shutdown-Eingangs auf Bezugspotential beendet ist. Die Dimensionierung der Bauteile wird mit an dieser Forderung orientiert.

Zum Abschalten wird der Taster 5 gebraucherindividuell mehrmalig oder einmalig eine Mindestzeit gedrückt. Es soll/muss eine bewusste Manipulation des Benutzers sein. Bei mehrmaligem Drücken des Tasters 5 könnte das beispielsweise mit fester Wiederholfrequenz geschehen oder morseartig oder nach einem Rhythmus ablaufen.
Die Tastfolge muss für den Benutzer eingängig und einfach sein, sie darf wegen des Schaltvorganges nicht beliebig, bzw. zu lange sein. Bei einmaligem Drücken wäre einfach nur ein Mindesttastzeit einzuhalten, die das bewusste Drücken zum Ausdruck bringt und es als solches erkennen lässt. Für das Muster des Tasterdrückens bestehen somit große Freiheiten, die ein individuell beschränktes Nutzen ermöglichen. Mit dieser gebraucherindividuellen Tastfolge ist dann die kontinuierliche Überwachung des Tasters durch den Mikrocontroller unproblematisch.
Für die intervallweise Überwachung muss bei willkürlichem Tastendruck im Microcontroller sofort eine Plausibilitätsprüfung wie beim kontinuierlichen Überwachen anlaufen/starten. Die Plausibilitätsprüfung prüft die Struktur der Tastsequenz für das gewollte Schalten und verlangt keine punktgenaue Abfolge des Tasterdrückens.

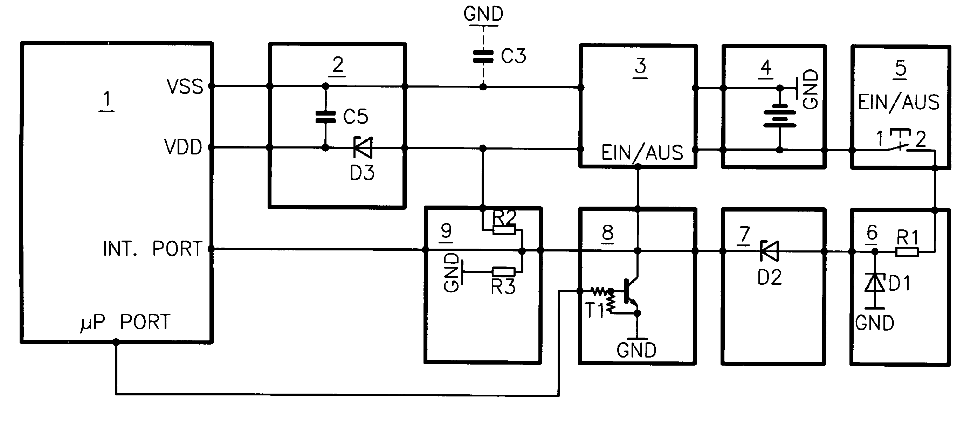

Die einzige Figur der Beschreibung zeigt den blockartigen Aufbau für *die Überwachungsschaltung mit einem Mikrocontroller 1,* wie sie beispielsweise zum Ein- und Ausschalten einer elektronischen Handprothesensteuerung konzipiert wurde. Der Taster 5 befindet sich innerhalb der Handprothese. Um die Kompatibilität zu Prothesen namhafter Prothesenhersteller zu wahren, wurde die Prothese so konstruiert, dass daran angeschlossen werden kann. Innerhalb des Schafts der Prothese befinden sich 2 Myoelektroden und der Akku-/Batterieschacht. Der Schaft wird durch ein drehbares Gelenk, das mit einem vierpoligen Drehkontakt ausgestattet ist, mit der eigentlichen Handprothese verbunden. Über die 4 Drehkontakte werden die Versorgungsspannung und die Steuersignale von den Myoeleektroden zu der Handprothese übertragen. Es gibt nur eine gemeinsame Masseverbindung für die Steuersignale und die Stromversorgung des Antriebmotors. Eine Abschaltung der Stromversorgung innerhalb des Schaftes ist nicht vorgesehen.

Das kann technisch elementar durch Wegnahme des Akkus aus dem Schaft erfüllt werden.

Benutzerfreundlichkeit und größere Freiheit besteht jedoch, wenn die Steuerelektronik und der Antriebmotor ein- und ausgeschaltet werden können. Hierzu ist in diesem beispielhaften Fall ein Schalter mit ca. 3 - 5 A zu schalten. Dazu wird eine Schutzvorrichtung benötigt, die die Gefahr ausschließt, den Schalter während der Benutzung der Handprothese wegen der problematischen Folgen unabsichtlich zu betätigen. Der oben beschriebene, intelligente microcontrollerüberwachte Schalter und das mit ihm durchführbare, kontrollierte Abschalten vermeiden die nicht absehbaren Folgen eines unkontrollierten Abschaltens einer Handprothese.

An dem Microcontroller 1 der Figur sind lediglich die wesentlich elektronischen Anschlusskontakte hervorgehoben. Übliche elektronische Anschlüsse für untergeordnete Steuerungen, Zustandsanzeigen, Signaleinrichtungen sind nicht angedeutet, da sie von Fall zu Fall nach Aufgabenstellung vom durchschnittlichen Elektroniker eingerichtet werden. An die beiden Anschlüsse VSS und VDD ist der Energiespeicher in Form des Kondensators C5. Die zweite elektronische Rückflusssperre ist durch die Diode D3 angedeutet. An den Energiespeicher 2 schließt sich der Spannungsregler 3 mit seinen Ein/Aus-Kontakt, dem in der Fachsprache geläufigen Shutdown-Kontakt, kurz SHD, an. Der Spannungsregler 3 ist der das Ein- und Ausschalten exekutierende Block.

Die Batterie 3, der Akku, folgt dem Spannungsregler 3. Der Taster 5 mit dem angedeuteten, benutzten Schließerkontakt ist direkt und fest an den Pluspol des Akkus angeschlossen. Die andere Seite des Tasters 6 ist mit dem Spannungsbegrenzer 6 mit angedeutetem Widerstand R1 und angedeuteter, auf Masse, GND, liegender Diode D1. Dem Spannungsbegrenzer schließt sich die erste elektronische Rückflusssperre 7 an, die durch die Diode D2 symbolisiert ist. Der Ausgang der Rückflusssperre 7 und damit der Diode D2 führt auf das Schaltelement 8, das durch den auf Masse gelegten Transistor T1 symbolisiert ist. Über die Drahtverbindung von dem Schaltelement 8 zum Shutdown-Kontakt des Spannungsreglers 3 ist die spannungsbegrenzte Batteriespannung für den Schließmoment des gedrückten Tasters 5 am Shutdown-Kontakt des Spannungsreglers 3. Es existiert aber auch eine direkte feste Verbindung vom Shutdown-Kontakt bzw. dem Transistor T1 über den Spannungsteiler 9 auf den Überwachungskontakt INT.Port am Microcontroller 1.

Der Spannungsteiler 9, angedeutet durch die auf Masse gelegte Widerstandskette R2 und R3, liegt mit dem Eingang der Widerstandskette am Ausgang des Spannungsreglers bzw. am Eingang des Energiespeichers 2 und dort an der Anode der Diode D3.

Der Transistor T1 im Schaltelement 8 ist mit seiner Basis an den Steuerkontakt µP PORT des Microcontrollers angeschlossen, über ihn wird das Potential am Shutdown-Kontakt eingestellt.

Um mit Initiierung des Abschaltens nicht auch das Leeren des Energiespeichers 2 zu initiieren, sondern das verzögert beginnen lassen zu können, ist auf dem VSS-seitigen Potential des Spannungsreglers der Kondensator C3 angeschlossen, an dem eine Spannung zur Masse eingestellt werden kann, die bei voll geladenem Kondensator C3 größer ist als die Spannung am Kondensator C5 des Energiespeichers, wodurch über eine entsprechende Diodenbeschaltung zunächst der Microcontroller 1 nur über den zusätzlichen Kondensator C3 und nicht über den Kondensator C5 mit Energie versorgt wird. Bei längerer Austastungssequenz z. B. eine nützliche Schaltungsmaßnahme.

## Patentansprüche

1. Überwachungsschaltung mit einem Mikrocontroller (1) für einen Schalter zum Ein- und Ausschalten einer Steuerelektronik, bestehend aus:
- einem Taster (5) mit zwei Anschlüssen, dessen erster Anschluss an eine Batterie (4), gefolgt von einem Spannungsregler (3) und dessen zweiter Anschluss an einen Spannungsbegrenzer (6), gefolgt von einer ersten elektronischen Rückflusssperre (7) und einem Schaltelement (8), angeschlossen ist,
- wobei das Schaltelement (8) mit einem Bezugspotential und mit dem Shutdown-Eingang (Ein/Aus), des Spannungsreglers (3) verbunden ist, wobei der Shutdown-Eingang (Ein/Aus) über einen Spannungsteiler (9) mit dem Ausgang des Spannungsreglers (3) verbunden und an den als Überwachungsport definierten Kontakt (Int.Port) des Mikrocontrollers (1) angeschlossen ist,
- einem an den Spannungsregler (3) angeschlossenen Energiespeicher (2) mit elektronischer Rückflusssperre, der mit einem Versorgungskontakt (VSS) und einem Kontakt auf Bezugspotential (VDD) des Mikrocontrollers (1) verbunden ist.

2. Überwachungsschaltung nach Anspruch 1, **dadurch gekennzeichnet, dass** der Spannungsregler (3) über den Shutdown-Eingang, SHD, ein- und ausschaltbar ist.

3. Überwachungsschaltung nach Anspruch 2, **dadurch gekennzeichnet, dass** beim Abschalten zur Vermeidung der sofortigen Entladung des Energiespeichers mit zweiter elektronischer Rückflusssperre (2) ein Kondensator C3 an den auf dem Versorgungskontakt VSS liegenden Ausgang des Spannungsreglers (3) angeschlossen ist.

4. Verfahren zum Betreiben der Überwachungsschaltung nach einem den Ansprüchen 1 bis 3, bestehend aus den Schritten:
Einschalten:
zum Einschalten wird der Taster (5) gedrückt und seine beiden verwendeten Kontakte dadurch überbrückt, wodurch die im Spannungsbegrenzer (6) reduzierte Batteriespannung über die erste elektronische Rückflusssperre (7) an dem Shutdown-Eingang des Spannungsreglers (3) angelegt wird und ihn dadurch einschaltet,
durch den eingeschalteten Spannungsregler (3) wird der Microcontroller (1) über den Energiespeicher mit der zweiten elektronischen Rückflusssperre (2) energetisch versorgt,
der Shutdown-Eingang am Spannungsregler (3) wird über den Spannungsteiler (9), der an einen stabilisierten Ausgang des Spannungsreglers (3) angeschlossen ist, auf dem anfänglich Pegel, High-Pegel, gehalten und bleibt damit selbsthaltend eingeschaltet,
in diesem Zustand wird die Kontrolle über den Zustand des Schalters von einem ursprünglich eingeprägten Überwachungsprogramm im Microcontroller übernommen,
Abschalten:
beim programmfestgelegten, gebraucherindividuell angepassten Betätigen des Tasters (5) wird an dem Kontakt für die Zustandsüberwachung, int. Port, des Mikrocontrollers (1) ein High-Pegel > 0,25 x Vdd registriert, worauf nach einer Plausibilitätsprüfung der gebraucherindividuell angepassten Betätigung des Tasters (5) die programmfestgelegte Abschaltsequenz eingeleitet wird,
von dem Microcontroller (1) werden dann vollends alle laufenden Prozesse gemäß dem eingeprägten Überwachungsprogramm beendet, der Abschaltvorgang eingeleitet und durchgeführt, um den Spannungsregler abzuschalten, wird auf dem Steuerkontakt, pP-Kontakt, des Microcontrollers (1) ein High-Potential angelegt und an den Steuereingang des Schaltelements (8) geleitet, wodurch das Schaltelement (8) in den leitenden Zustand versetzt wird und damit der SHD-Eingang des Spannungsreglers (3) auf Bezugspotential des Schaltelements (8), wodurch der Spannungsregler (3) programmgemäß abschaltet, während dieses Abschaltens wird der Microcontroller (1) über den Energiespeicher mit der zweiten elektronischen Rückflusssperre (2) so lange energetisch versorgt, bis der Abschaltvorgang durch das Überführen des Schaltelements (8) in den leitenden Zustand und damit dem Legen des Shutdown-Eingangs auf Bezugspotential beendet ist.

5. Verfahren nach Anspruch 4, **dadurch gekennzeichnet, dass** zum Abschalten der Taster (5) gebraucherindividuell mehrmalig oder einmalig eine Mindestzeit gedrückt wird.

6. Verfahren nach Anspruch 5, **dadurch gekennzeichnet, dass** der Taster (5) kontinuierlich oder intervallweise über den Microcontroller (1) überwacht wird.
